# EUROPEAN PATENT APPLICATION

(11) **EP 1 420 459 A2**
(43) Date of publication of application: **19.05.2004**
(21) Application number: 03025984.0
(22) Date of filing: 13.11.2003
(51) Int. Cl.: H01L 31/042, H01L 31/02

(54) **Solar cell module**

(30) Priority: 14.11.2002 JP 2002330158; 31.10.2003 JP 2003371764
(71) Applicant: CANON KABUSHIKI KAISHA, Ohta-ku, Tokyo (JP)
(72) Inventor: Takehara, Nobuyoshi, Tokyo (JP)
(74) Representative: Leson, Thomas Johannes Alois, Dipl.-Ing.

(57) **Abstract**

The present invention provides a solar cell module comprising one or more solar cells, one or more bypass diodes, an electric output connection section, and a weather-resistant enclosure, characterized in that a projecting portion and a hole portion which are to be connected to each other and which have predetermined sizes are provided at predetermined positions, as means for indicating electrical compatibility determined on the basis of the rated current value of the bypass diode and the nominal short-circuit current value of the solar cell module. This allows even a user without any advanced technical knowledge to replace a solar cell module safely and easily.

## Description

### BACKGROUND OF THE INVENTION

### Field of the Invention

The present invention relates to a solar cell module that can be replaced more safely and efficiently.

### Related Background Art

More and more residential photovoltaic power generating systems have been rapidly put to practical use. A large number of photovoltaic power generating systems are being operated in the market. With an increase in the number of these systems, the absolute number of failures occurring in the market tends to increase. More and more cases have thus been reported in which solar cell modules must be replaced.

As a technique for replacing solar cell modules, Japanese Patent Application Laid-Open No. 2002-222978 (USAA2002059952) discloses a method of replacing a group of solar cells together.

Furthermore, Japanese Patent Application Laid-Open No. 2000-307144 describes the installation of solar cell modules having different current rates.

Many photovoltaic power generating systems are provided with bypass diodes in order to prevent the systems from being under partial shadow. The bypass diodes are designed to withstand a current equivalent to a short-circuit current from solar cells. However, if a solar cell module with a different current rate is selected for replacement, a current from a solar cell module with a high current rate may flow into the bypass diodes in a solar cell module with a low current rate to cause overheat. To present such a situation, the compatibility of the modules must be checked on the basis of the characteristics of the bypass diodes and the generation characteristics of the solar cells. This is very cumbersome and it is virtually impossible for field service personnel to achieve this operation.

### SUMMARY OF THE INVENTION

The present invention has been accomplished to solve the above problems. It is an object of the present invention to allow even a person having no advanced expert knowledge to replace solar cell modules safely and easily.

To accomplish this object, the present invention provides a solar cell module comprising one or more solar cells, one or more bypass diodes, an electric output connection section, and a weather-resistant enclosure, wherein the solar cell module further comprises a member or a site indicating electrical compatibility determined on the basis of a rated current value of the bypass diodes and a nominal short-circuit current value of the solar cell module.

This enables the easy selection of solar cell modules, which are electrically compatible with each other, i.e., ones that can be conveniently used for replacement. Therefore, compatibility can be very easily checked in the field.

### BRIEF DESCRIPTION OF THE DRAWINGS

FIG. 1 is a schematic view showing an example of a solar cell module according to the present invention;
FIG. 2 is a schematic view showing another example of a solar cell module according to the present invention;
FIG. 3 is a schematic view showing yet another example of a solar cell module according to the present invention;
FIG. 4 is a view illustrating an example of compatibility rank areas utilized in the present invention;
FIG. 5 is a view illustrating another example of compatibility rank areas utilized in the present invention;
FIG. 6 is a view showing an example of a solar cell array constructed using solar cell modules according to the present invention; and
FIG. 7 is a view showing an example of a conventional solar cell module.

### DESCRIPTION OF THE PREFERRED EMBODIMENTS

Embodiments of the present invention will be described below with reference to the drawings. However, the present invention is not limited to the embodiments.

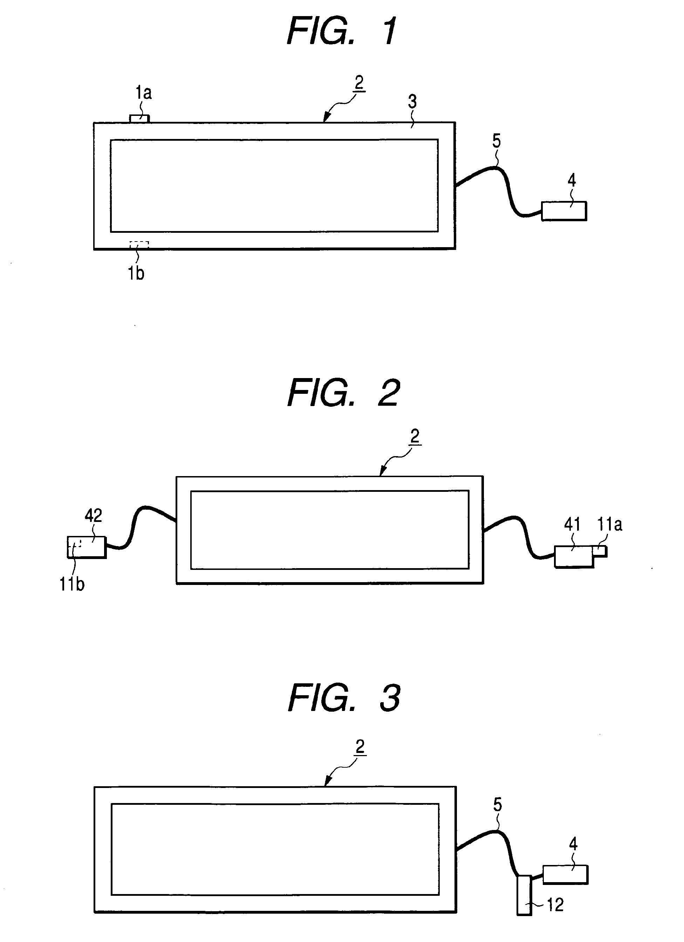

FIG. 1 shows an example of a solar cell module to which the present invention has been applied. The solar cell module according to the present invention has a structure formed by sealing solar cells and bypass diodes with a weather-resistant resin in an enclosure. The constitutional requirements of the present invention will be described below.

### (Solar Cell)

The solar cells are composed of a well-known common material such as crystalline silicon, amorphous silicon, or microcrystalline silicon. Thus, the type of the solar cells used in the present invention is not particularly limited. What is important is the nominal short-circuit current value of the solar cells. On the basis of this value, a compatibility rank code, described below, is determined. The nominal short-circuit current value as referred to herein is generally used under the conditions of AM 1.5, 100 mV/cm², and 25°C. Furthermore, the nominal short-circuit current value is almost proportional to an optimum operation current. Accordingly, in implementation of the present invention, the optimum operation current may be used as an index for selection.

### (Bypass Diode)

The bypass diodes are connected in parallel with the solar cells and, during light interception of a solar cell, used to bypass a generation current from another solar cell. Operations of the bypass diodes and the number of bypass diodes required are disclosed in well-known documents such as "Solar Cell Handbook" edited by Solar Cell Examination Technical Committee of the Institute of Electrical Engineers of Japan. Thus, these matters are not described in detail herein. In the present invention, silicon PN junction diodes or shot key diodes are used as the diode. What is important in the present invention is the rated current value of the bypass diodes. On the basis of this value, the compatibility rank code, described later, is determined. The term rated current value refers to an absolute maximum rated current specified on a catalogue or the absolute maximum rated current multiplied by a safety factor determined taking an increase in temperature into account. In short, this term refers to the "value of a current that can flow through the diode."

### (Enclosure)

The enclosure protects the solar cells from the air or moisture to make the solar cell module rigid. A very general configuration is disclosed in well-known materials such as documents such as "Solar Cell Handbook" edited by Solar Cell Examination Technical Committee of the Institute of Electrical Engineers of Japan. The enclosure is composed of a weather-resistant resin, a metal laminate sheet for a back surface, and an aluminum frame. In a building-material integrated type solar cell disclosed in Japanese Patent Application Laid-Open No. 2000-252510, solar cells are placed on a metal roof material instead of the aluminum frame or the back surface sheet and are sealed with a weather-resistant resin. There are no particular requirements for the enclosure in the implementation of the present invention.

### (Electric Output Connection Section)

The solar cells are connected in series inside the solar cell module, and currents from them are output through the electric output connection section. This section is often composed of a cable 5 and a connector 4 or a junction box. Recently, the type including the cable and connector has been popular because it can be more easily connected to the enclosure.

### (Rank Code for Indicating Compatibility)

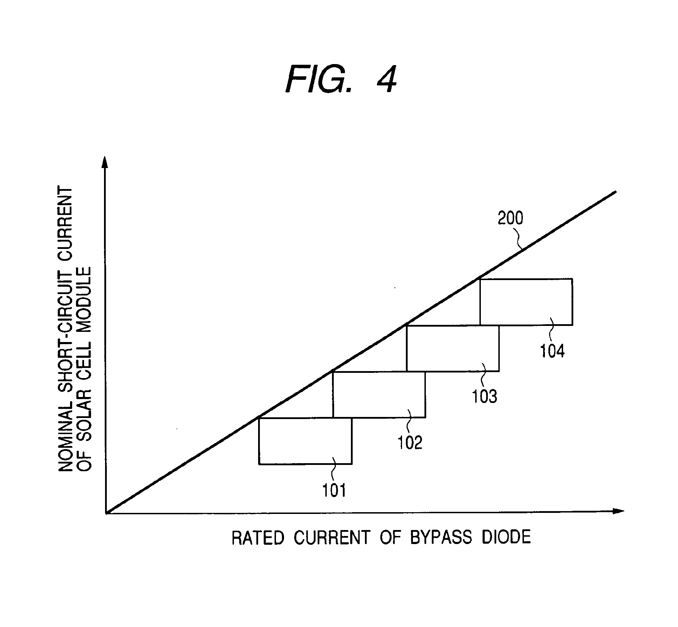

A concept constituting the core of the present invention is ranks representative of electric compatibility. The compatibility ranks can be indicated using any of the various means including characters, projections and colors. It may be stored in a radio ID chip or the like. It is essential to determine the compatibility rank outside the solar cell module using any means. With reference to FIG. 4, description will be given of a specific method of specifying the compatibility rank codes.

In FIG. 4, the axis of ordinate indicates the nominal short-circuit current value of the solar cell module. The axis of abscissa indicates the rated current value of the bypass diodes. A straight line 200 represents the minimum required rated current value of the bypass diodes used for a solar cell module having a certain short-circuit current value. Rectangular areas denoted by 101 to 104 each represent a compatibility rank. Each of the rectangular areas 101 to 104 has its upper left vertex on the straight line 200 or close to the straight line 200 so that it does not project across the line 200. The rectangles do not overlap one another. This ranking meets the condition that the "rated current of the bypass diodes is always larger than the short-circuit current (the worst condition)." Accordingly, the "replacement of the module with an appropriate one," which is the object of the present invention, can be accomplished. The size of each rectangular area may be properly determined. However, the lower right part of each rectangular area corresponds to the condition that although the short-circuit current is small, the rated current of the bypass diodes is large. This disadvantageously increases costs. In view of this, the form in FIG. 4 is desirable in which the compatibility rank areas are arranged along the vicinity of the straight line 200.

The straight line 200 essentially passes through an origin and is used to keep the ratio of the rated current of the bypass diodes to the short-circuit current at a fixed value. According to IEEE 1262-1995 (IEEE Recommended Practice for Qualification of Photovoltaic (PV) Modules) relating to solar cell modules, the bypass diodes withstand a current 1.25 times as large as the short-circuit current. If this condition is to be met, the ratio of the rated current of the bypass diodes to the nominal short-circuit current may be 1.25 or more. The straight line 200 may correspond to the worst possible condition.

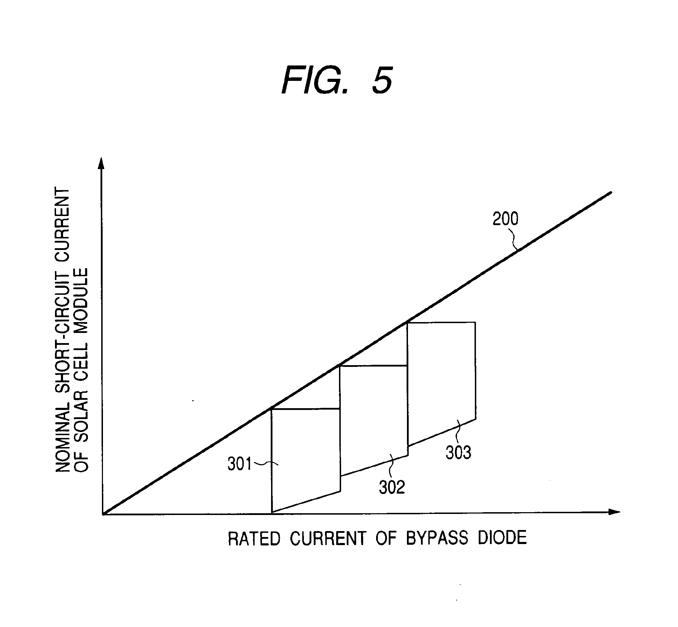

It is convenient in terms of practical use to use the above rectangular areas as compatibility ranks. The essential requirement of the present invention is that the bypass diodes of all the solar cell modules belonging to a certain compatibility rank have a rated current value equal to or larger than the minimum bypass diode rated current value required by the solar cell module having the largest nominal short-circuit current in that rank. In a graphical expression using FIG. 4, this requirement corresponds to an area located to the right side of the vertical line of the rectangle of FIG. 4 and below the upper horizontal line of the rectangle. Provided that this condition is met, for example, trapezoidal areas may be used as shown by 301 to 303 in FIG. 5, or the ranks may be set so that bypass diodes with the same rated current do not belong to multiple ranks, or the areas may be arranged at certain intervals so as to be completely separated from another, i.e., the ranks are arranged like islands.

In other words, this has the same meaning that "the bypass diode rated current value and nominal short-circuit current value of the module contained in any of the above areas are considered to be values in the upper left corner of this area." Accordingly, the compatibility code may be considered to correspond to a particular combination of the nominal short-circuit value of the module with the bypass diode rated current value on a one-to-one basis. Furthermore, the short-circuit current of the solar cell module is generally proportional to its maximum output and optimum operation current. Thus, their values can be used as ranking parameters in place of the short-circuit current value. However, it should be noted that in a technical sense, this ranking is also based on the relationship between the short-circuit current and the bypass diode rated current.

In the present invention, as the means (member or site) for indicating electric compatibility, it is preferable to utilize compatibility ranks or compatibility codes determined as described above. The applications of the compatibility ranks are classified into two categories; in one of the categories, the modules belonging to different ranks are not geometrically compatible with one another, and in the other category, the modules are differently colored for visibility.

In the present invention, the means for indicating electric compatibility is preferably provided on the electric output connection section and/or the weather-resistant enclosure. Then, when replacing the solar cell module with a new one, even a person having no advanced expert knowledge can easily check the modules for electric compatibility. Consequently, the solar cell module can be replaced stably and easily.

The above-described system utilizing the compatibility rank codes has been originally invented by the inventor. The employment of the present system ensures compatibility with virtually any solar cells independent of the type and manufacture of the solar cell module.

Examples of the present invention will be described below. However, the present invention is not limited to these examples.

### (Example 1)

Solar cell modules according to this example has no geometrical compatibility of the enclosure with one another between the modules with different compatibility ranks. FIG. 1 shows an example of a solar cell module according to the present example.

The solar cell module 2 shown in FIG. 1 is based on what is called a super straight system. Solar cells are sealed between a front surface protective glass and a back surface laminate sheet with a weather-resistant resin. The periphery of the module 2 is protected by a metal frame 3 so as to be rigid.

In the implementation of the present invention, the metal frame 3 is provided with a projection 1a and a hole portion 1b into which the projection is fitted, the projection 1a and the hole portion 1b being composed of a bolt and a nut, respectively. The positions of the projection 1a and hole portion 1b correspond to the compatibility rank codes.

In the present example, the compatibility rank codes were assigned as described below. This assignment corresponds to the form shown in FIG. 4.
(1) A compatibility rank code "A" to a bypass diode rated current of 6 A (6 A or more and less than 9 A) and a nominal short-circuit current of 5 A (more than 3.6 A and 5 A or less)
(2) A compatibility rank code "B" to a bypass diode rated current of 8 A (8 A or more and less than 11 A) and a nominal short-circuit current of 6.4 A (more than 5 A and 6.4 A or less)
(3) A compatibility rank code "C" to a bypass diode rated current of 10 A (10 A or more and less than 13 A) and a nominal short-circuit current of 8 A (more than 6.4 A and 8 A or less)

Thus, only one compatibility code is provided to a particular combination of the bypass diode current value and the nominal short-circuit current value. Such combinations may be arbitrarily defined. A group of the modules "considered to" have these values is treated as one area. Consequently, when the modules are connected in series, they can be made perfectly compatible with one another.

The module outside the areas, e.g., the module having a bypass diode rated current of 7 A and a nominal short-circuit current of 5.6 A is not classified into A or B. Such module is what is called "out of standard" and is not ensured to be safely used with the group of the modules in the present example. To enjoy the effects of the present invention, it is necessary to employ a bypass diode rated current of 8 A or more to a solar cell module, and which is classified into the compatibility rank code B, or to subdivide the rank codes to obtain smaller compatibility areas.

If each compatibility area is too large, a large bypass diode rated current is required relative to the short-circuit current. This increases module costs. On the other hand, if each compatibility area is too small, compatible solar cell modules are subdivided. This degrades the convenience of the compatibility codes. Thus, in a practical sense, it is desirable to define compatibility codes at several-A increments as described above.

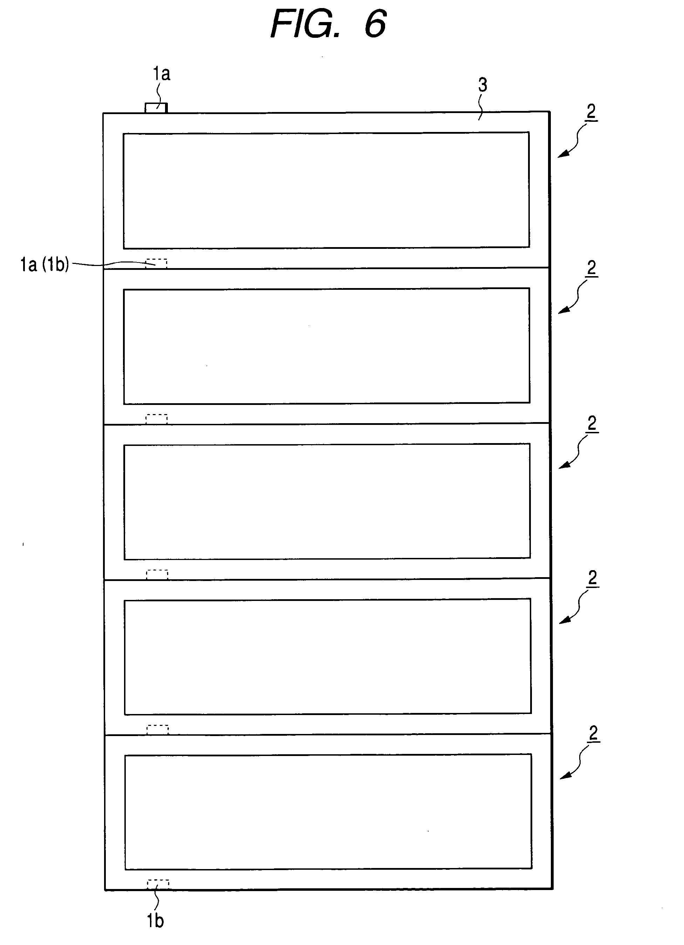

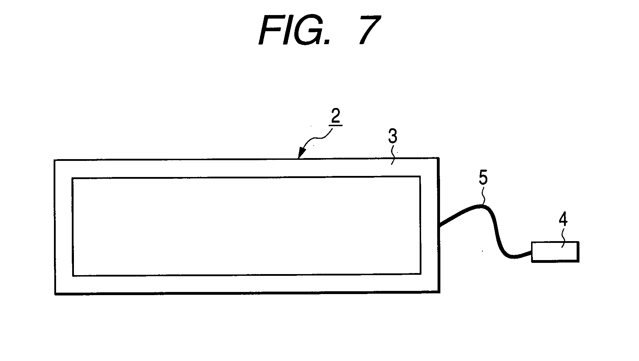

FIG. 6 shows a solar cell array made by combining solar cell modules each of which is shown in FIG. 1 (the cable 5 and the connector 4 are not shown). Each projection 1a is fitted into the corresponding hole portion 1b to assemble the modules into the array without creating any gaps. If the projection is not positioned so as to be fitted into the corresponding hole portion, the corresponding modules cannot be assembled together. Accordingly, a person having no advanced expert knowledge can recognize incompatibility. This arrangement is only an example. Various changes may be made to the positions of the projection and hole portion on the frame and the shapes as well as the numbers of projections and hole positions without departing from the spirits or objects of the present invention. It is essential to set the positions and sizes of the modules in association with the "compatibility ranks." This enables every person to recognize compatibility. In contrast, the conventional solar cell module as shown in FIG. 7 is not provided with any members for compatibility, and therefore erroneous replacement operation of the conventional module may be performed.

### (Example 2)

In a solar cell module according to the present example, a connector of the module is shaped to correspond to a compatibility rank code. FIG. 2 shows an example of a solar cell module according to the present example. The compatibility rank code is provided as described in the above example.

In the solar cell module 2 shown in FIG. 2, a male connector 41 is provided with a projection 11a shaped to correspond to an appropriate compatibility rank. A female connector 42 is provided with a hole portion 11b shaped to correspond to the appropriate compatibility rank. Thus, upon an electric connection, the compatibility rank can be determined depending on whether the connectors can be fitted into each other. The details of the internal structures of solar cell connectors are disclosed in Japanese Patent Application Laid-Open No. H11-329549 and other documents. These structures are unrelated to the essence of the present invention and will not be described in detail.

### (Example 3)

In the present example, a solar cell module is provided with visibility based on the compatibility rank codes. FIG. 3 shows an example of a solar cell module according to the present example.

The solar cell module 2 shown in FIG. 3 is provided with a tag 12 on its cable portion, the tag having a color corresponding to an appropriate compatibility rank. The color of the tag 12 is arbitrary. Colors such as red, black, yellow and blue may be properly determined for the respective ranks described above. Furthermore, a material for the tag and the position at which the tag is provided are not restricted. Radio ID chips, which have recently been popular, may be used. However, for easy recognition, direct display based on colors or the like is more suitable for the implementation of the present invention. As an alternative embodiment for providing visibility based on the compatibility codes, it is possible to, for example, impress seals on the cables or connectors or to use characters or symbols. With characters, a single alphabet standing for each rank may be placed on a well-known rate display label or the like.

The compatibility ranks can be more easily recognized by providing visibility based on the compatibility codes, while simultaneously improving the geometric compatibility as in the case with the previously described example. Therefore, solar cell modules can be very efficiently replaced with new compatible solar cell modules.

As described above, the solar cell module according to the present invention has means (member or site) for indicating electric compatibility determined on the basis of the nominal short-circuit current value of the solar cells and the rated current value of the bypass diodes. This enables the easy selection of a solar cell module having good electrical compatibility, i.e., a solar cell module that can be conveniently used for replacement. Therefore, compatibility can be very easily checked in the field.

The present invention provides a solar cell module comprising one or more solar cells, one or more bypass diodes, an electric output connection section, and a weather-resistant enclosure, characterized in that a projecting portion and a hole portion which are to be connected to each other and which have predetermined sizes are provided at predetermined positions, as means for indicating electrical compatibility determined on the basis of the rated current value of the bypass diode and the nominal short-circuit current value of the solar cell module. This allows even a user without any advanced technical knowledge to replace a solar cell module safely and easily.

## Claims

1. A solar cell module comprising: one or more solar cells, one or more bypass diodes, an electric output connection section, and a weather-resistant enclosure, wherein the solar cell module further comprises a members or a site indicating electrical compatibility determined on basis of a rated current value of the bypass diodes and a nominal short-circuit current value of the solar cell module.

2. The solar cell module according to claim 1, wherein the member or site indicating the electric compatibility is provided on the electric output connection section and/or the weather-resistant enclosure.
